# EUROPEAN PATENT APPLICATION

(11) **EP 4 141 960 A1**
(43) Date of publication of application: **01.03.2023**
(21) Application number: 20931964.9
(22) Date of filing: 28.10.2020
(51) Int. Cl.: H01L 29/808, H01L 21/337

(54) **FIELD EFFECT TRANSISTOR HAVING SAME GATE AND SOURCE DOPING, CELL STRUCTURE, AND PREPARATION METHOD**

(30) Priority: 20.04.2020 CN 202010313779; 20.07.2020 CN 202010700174; 24.07.2020 CN 202010725690
(71) Applicant: PN Junction Semiconductor (Hangzhou) Co., Ltd., Hangzhou, Zhejiang 311200 (CN)
(72) Inventor: HUANG, Xing, Hangzhou, Zhejiang 311200 (CN); CHEN, Xin Lu, Hangzhou, Zhejiang 311200 (CN)
(74) Representative: Osha Liang
(86) International application number: PCT/CN2020/124344
(87) International publication number: WO 2021/212793

(57) **Abstract**

Disclosed are a field effect transistor having same gate and source doping, a cell structure, and a preparation method. The cell structure for a field effect transistor having same gate and source doping includes: a silicon carbide substrate with a doping type of a first conductivity type; a semiconductor epitaxial layer of the first conductivity type and a first electrode respectively provided on front and back faces of the silicon carbide substrate; and a floating region of a second conductivity type, a gate implantation region of the first conductivity type, and a source implantation region of the first conductivity type sequentially provided on the semiconductor epitaxial layer of the first conductivity type, wherein a gate is provided on the gate implantation region, a source is provided on the source implantation region, an inter-electrode dielectric is provided between the gate implantation region and the source implantation region, and the inter-electrode dielectric is used for isolating the gate from the source.

## Description

### Field of the Invention

The present disclosure belongs to the field of semiconductor technology, and in particular relates to a field effect transistor having the same gate and source doping, a cell structure, and a preparation method.

### Background of the Invention

With the development and maturity of material technologies, the wide bandgap characteristics of SiC materials allow higher temperature characteristics and voltage endurance characteristics thereof, which can break through the limitations of Si-based devices. Because the performance and reliability of SiC/SiO2 interfaces still need to be further improved, the structures of SiC Junction Field Effect Transistor (JFET) device have received extensive attention. In addition to avoiding the problems caused by SiC/SiO₂ interface defects, it is easier to reduce a cell size of SiC JFETs to reach lower on-resistance. Because more interface states are excited in SiO₂ at high temperatures, SiC JFET devices may maximize the characteristics of SiC materials at high temperatures and high pressures.

A traditional SiC JFET is controlled by PN junctions. Charge carriers flow out from a source of a device, then pass through a long and narrow channel region, flow into a drift region of the device, and are finally collected by a drain of the device. The channel of the device is controlled by two PN junctions located between the gate and the source, so as to control the turn-off and turn-on of the device. However, a P-type gate of the traditional JFET brings many adverse effects on the device application level: first, when the device is turned on, in order to avoid the turn-on of the PN junctions, a gate bias voltage Vgs of the device cannot exceed the forward cut-in voltage V_{F0} of the PN junctions (taking silicon carbide for example, V_{F0}=2.6 V, that is, Vgs < V_{F0}); meanwhile, if the device is normally-on, when it is turned on at zero gate bias voltage, a built-in potential (hereinafter referred to as "gate built-in potential") formed between the P-type gate and the N-type channel depletes the channel to a certain extent, resulting in relatively high channel resistance; and when the device is operating at a high current (nearly saturated), the gate built-in potential causes the channel to enter a pinch-off state prematurely, resulting in premature current saturation and excessive conduction loss during this operation.

### Summary of the Invention

In view of the above existing technical problems, the present disclosure provides a field effect transistor having same gate and source doping, a cell structure, and a preparation method.

In order to solve the above technical problems, the present disclosure adopts the following technical solutions.

A first aspect of the present disclosure provides a cell structure for a field effect transistor having same gate and source doping, including:
a silicon carbide substrate, wherein a doping type of a material of the silicon carbide substrate is a first conductivity type,
a semiconductor epitaxial layer of the first conductivity type and a first electrode respectively provided on front and back faces of the silicon carbide substrate; and
a floating region of a second conductivity type, a gate implantation region of the first conductivity type, and a source implantation region of the first conductivity type sequentially provided on the semiconductor epitaxial layer of the first conductivity type, wherein a gate is provided on the gate implantation region, a source is provided on the source implantation region, an inter-electrode dielectric is provided between the gate implantation region and the source implantation region, and the inter-electrode dielectric is used for isolating the gate from the source.

Preferably, a portion of the floating region (005) of the second conductivity type in contact with the source implantation region (007) of the first conductivity type has the same structure as the source implantation region (007) of the first conductivity type, and both are provided with terminal sharp angles.

Preferably, the terminal sharp angles are 0-180 degrees.

Preferably, the semiconductor epitaxial layer (002) of the first conductivity type has a thickness of 5-250 µm and a doping concentration of 1×10¹⁴ cm⁻³ - 5×10¹⁸ cm⁻³.

Preferably, the gate implantation region on one side of the cell is connected to the gate, and the gate implantation region on another side of the cell and the source implantation region are jointly connected to the source.

Preferably, the doping for the first conductivity type and the second conductivity type is a uniform or non-uniform doping of 1×10¹⁴ cm⁻³ - 2×10²¹ cm⁻³.

Preferably, the first conductivity type is N type, and the second conductivity type is P type.

Preferably, the first conductivity type is P type, and the second conductivity type is N type.

A second aspect of the present disclosure provides a field effect transistor having same gate and source doping, the field effect transistor including a plurality of cell structures as described above and a field limiting ring junction termination. When the junction termination is fabricated, the junction termination and the floating regions of the second conductivity type of the cell structures are etched and implanted simultaneously using the same photolithography mask.

A third aspect of the present disclosure provides a field effect transistor having same gate and source doping, the field effect transistor including a plurality of cell structures as described above, a junction termination extension, and a junction termination with field limiting rings. When the junction termination is fabricated, the junction termination and the floating regions of the second conductivity type of the cell structures are etched and implanted simultaneously using the same photolithography mask .

A fourth aspect of the present disclosure provides a method for preparing a cell structure for a field effect transistor having same gate and source doping. The method includes the following steps.
(a) A silicon carbide substrate with a doping type of a first conductivity type is used. A semiconductor epitaxial layer of the first conductivity type is provided on a front face of the silicon carbide substrate. Using a photolithography plate (photolithography mask) to shield a portion of the surface, a silicon carbide mesa is formed by an etching process with an etching depth of 0.5 to 5 µm.
(b) Ion implantation of a floating region is performed by using the same photolithography mask. The specific process includes forming a floating region of the second conductivity type by at least one tilt implantation and vertical implantation of Al ions, so that bottom and side walls of a trench are uniformly implanted.
(c) The mask layer is peeled off and vertical N implantation is performed to form a gate implantation region and a source implantation region of the first conductivity type.
(d) A dielectric layer is grown on the side walls of the trench as an electrode isolation dielectric to isolate a gate from a source.
(e) A metal is deposited and an alloy is formed, by annealing, on surfaces of the gate implantation region, the source implantation region, and the substrate of the first conductivity type, respectively, as ohmic contacts. The alloy contains at least one of a silicide or a carbide.

Preferably, the steps further include: adding at least one tilt implantation to form a channel implantation region.

Preferably, the first conductivity type is N type, and the second conductivity type is P type.

Preferably, the first conductivity type is P type, and the second conductivity type is N type.

A fifth aspect of the present disclosure provides a method for preparing a field effect transistor having same gate and source doping, the field effect transistor including a plurality of cell structures and a field limiting ring junction termination. The cell structures are prepared by any of the methods as described above, and when the junction termination is fabricated, the junction termination and the floating regions of the second conductivity type of the cell structures are etched and implanted simultaneously using the same photolithography mask.

A sixth aspect of the present disclosure provides a method for preparing a field effect transistor having same gate and source doping, the field effect transistor including a plurality of cell structures, a junction termination extension, and a junction termination with field limiting rings. The cell structures are prepared by any of the methods as described above, and when the junction termination is fabricated, the junction termination and the floating regions of the second conductivity type of the cell structures are etched and implanted simultaneously using the same photolithography mask.

The present disclosure has the following beneficial effects.
(1) On the basis of the traditional JFET, a gate of a first conductivity type and a floating region of a second conductivity type that surrounds the gate are introduced to control the channel of the device, whereby the forward bias voltage of the gate of the device can be increased so that Vgs can be biased at a position greater than a forward cut-in voltage of a PN junction.
(2) When Vgs=0 V, because there is no reverse bias introduced by the built-in potential in the PN junction at the channel, the on-resistance of the device is lower.
(3) When turned on at a high current, the device enters a saturation state to conduct higher current.
(4) One gate is connected to the source, so that the structure allows a reduced Cgd, thereby reducing a switching loss.
(5) By introducing the floating region of the second conductivity type having terminal sharp angles, the implantation of the floating region of the second conductivity type can be completed by implantation in two directions, and the problem of the gate and the source become short-circuited during the implantation in two directions is solved.

### Brief Description of the Drawings

FIG. 1 is a schematic structural diagram of providing a semiconductor epitaxial layer of a first conductivity type on a front surface of a silicon carbide substrate according to method embodiment 1;
FIG. 2 is a schematic structural diagram of etching a silicon carbide mesa by an etching process according to Method Embodiment 1;
FIG. 3 is a schematic structural diagram of forming a floating region of a second conductivity type according to Method Embodiment 1;
FIG. 4 is a schematic structural diagram of forming a gate implantation region and a source implantation region according to Method Embodiment 1;
FIG. 5 is a schematic structural diagram of forming an electrode isolation dielectric according to Method Embodiment 1;
FIG. 6 is a schematic structural diagram of forming a gate and a source according to Method Embodiment 1;
FIG. 7 is a schematic structural diagram of forming a channel implantation region according to Method Embodiment 2;
FIG. 8 is a schematic structural diagram of connecting one gate to a source according to Method Embodiment 3;
FIG. 9 is a schematic structural diagram of simultaneous etching and implantation of a junction termination and an active region of cell structures according to Method Embodiment 4;
FIG. 10 is a schematic structural diagram of simultaneous etching and implantation of a junction termination and an active region of the cell structures according to Method Embodiment 5;
FIG. 11 is a schematic structural diagram of closing of a space charge region between the channel implantation region and the floating region of the second conductivity type when the device is turned off;
FIG. 12 is a schematic structural diagram of separation of a space charge region when the device is turned on;
FIG. 13 is a comparative schematic diagram showing that a voltage that can be applied to the gate is increased compared with a traditional JFET device;
FIG. 14 is a comparative schematic diagram showing that a saturation current is increased compared with a traditional JFET device;
FIG. 15 is a schematic cross-sectional structural diagram of a cell structure for a field effect transistor having same gate and source doping according to yet another embodiment of the present disclosure;
FIG. 16 is a schematic three-dimensional structural diagram of a semiconductor floating region of the second conductivity type having a terminal sharp angle in a cell structure for a field effect transistor having same gate and source doping according to yet another embodiment of the present disclosure;
FIG. 17 is a schematic cross-sectional structural diagram of a semiconductor floating region of the second conductivity type having a terminal sharp angle in a cell structure for a field effect transistor having same gate and source doping according to yet another embodiment of the present disclosure;
FIG. 18 is a top view of an active region layout of a device having cells with terminal sharp angles;
FIG. 19 is a schematic three-dimensional structural diagram of a rectangular semiconductor floating region of the second conductivity type in a cell structure for a field effect transistor having same gate and source doping according to yet another embodiment of the present disclosure;
FIG. 20 is a schematic cross-sectional structural diagram of a rectangular semiconductor floating region of the second conductivity type in a cell structure for a field effect transistor having same gate and source doping according to yet another embodiment of the present disclosure; and
FIG. 21 is a top view of an active region layout of a device having rectangular cells.

### Detailed Description of the Embodiments

The technical solutions in the embodiments of the present disclosure will be clearly and completely described below with reference to the accompanying drawings in the embodiments of the present disclosure. Apparently, the described embodiments are some, but not all, of the embodiments of the present disclosure. All other embodiments obtained by a person of ordinary skill in the art based on the embodiments of the present disclosure without creative efforts shall fall within the protection scope of the present disclosure.

### Method Embodiment 1

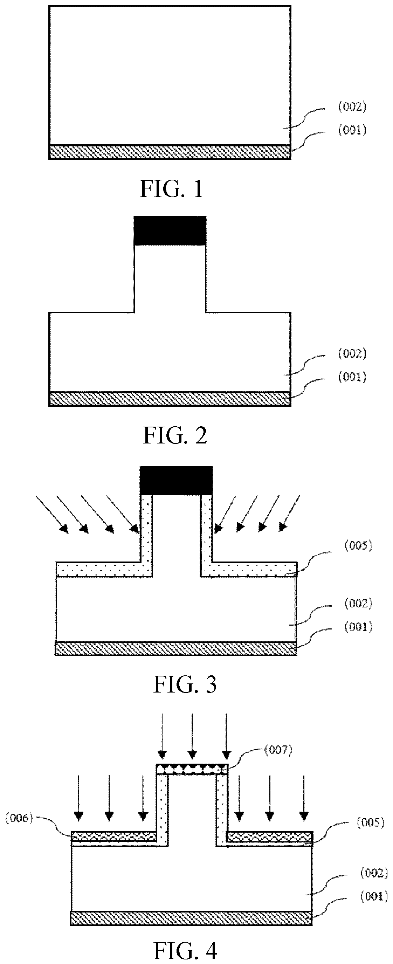

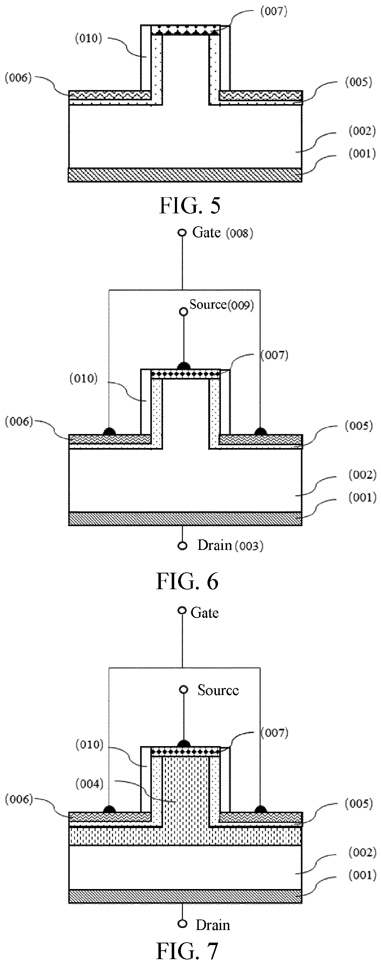

An embodiment of the present disclosure discloses a method for preparing a cell structure for a field effect transistor having same gate and source doping, including the following steps:
(a) With reference to FIG. 1 and FIG. 2, a silicon carbide substrate 001 with a doping type of a first conductivity type is used. A semiconductor epitaxial layer 002 of the first conductivity type is provided on a front face of the silicon carbide substrate 001. Using a photolithography plate (photolithography mask) to shield a portion of the surface, a silicon carbide mesa is etched using Inductively Coupled Plasma (ICP), with an etching depth of 0.5 to 5 µm. Other etching processes may also be used.
(b) With reference to FIG. 3, ion implantation of a floating region is performed by using the same photolithography mask. The specific process includes forming a floating region 005 of the second conductivity type by at least one tilt implantation and vertical implantation of Al ions, so that bottom and side walls of a trench are uniformly implanted.
(c) With reference to FIG. 4, the mask layer is peeled off, and vertical N implantation is performed to form a gate implantation region 006 and a source implantation region 007 of the first conductivity type, which then form good ohmic contacts with a metal.
(d) With reference to FIG. 5, a dielectric layer is grown on the side walls of the trench as an electrode isolation dielectric 010 to isolate the gate implantation region 006 from the source implantation region 007.
(e) With reference to FIG. 6, a metal is deposited and a silicide is formed, by annealing, on the surfaces of the first conductivity type of a gate, a source, and a drain, respectively, as ohmic contacts, *i.e.,* a gate, a source and a drain are formed.

Those skilled in the art can understand that, in some specific application examples, the first conductivity type is N type, and the second conductivity type is P type. In some other application examples, the first conductivity type is P type, and the second conductivity type is N type.

In a preferred application example, the doping of the first conductivity type and the second conductivity type is a uniform or non-uniform doping of 1×10¹⁴ cm⁻³ - 2×10²¹ cm⁻³.

In a preferred application example, the semiconductor epitaxial layer 002 of the first conductivity type has a thickness of 5-250 µm and a doping concentration of 1×10¹⁴ cm⁻³ - 5×10¹⁸ cm⁻³.

### Method Embodiment 2

On the basis of Method Embodiment 1, with further reference to FIG. 7, a channel implantation region 004 formed by at least one tilt implantation is added on the basis of step (b). The implantation energy this time is higher than the implantation energy of ion implantation of the floating region using the same photolithography mask, and the implantation this time is deeper, thereby changing the doping concentration of the epitaxial layer. The implantation energy does not stop at the surface of the trench, but reaches the channel, thereby increasing the implantation concentration of the channel, so as to further reduce the on-resistance Rdson.

### Method Embodiment 3

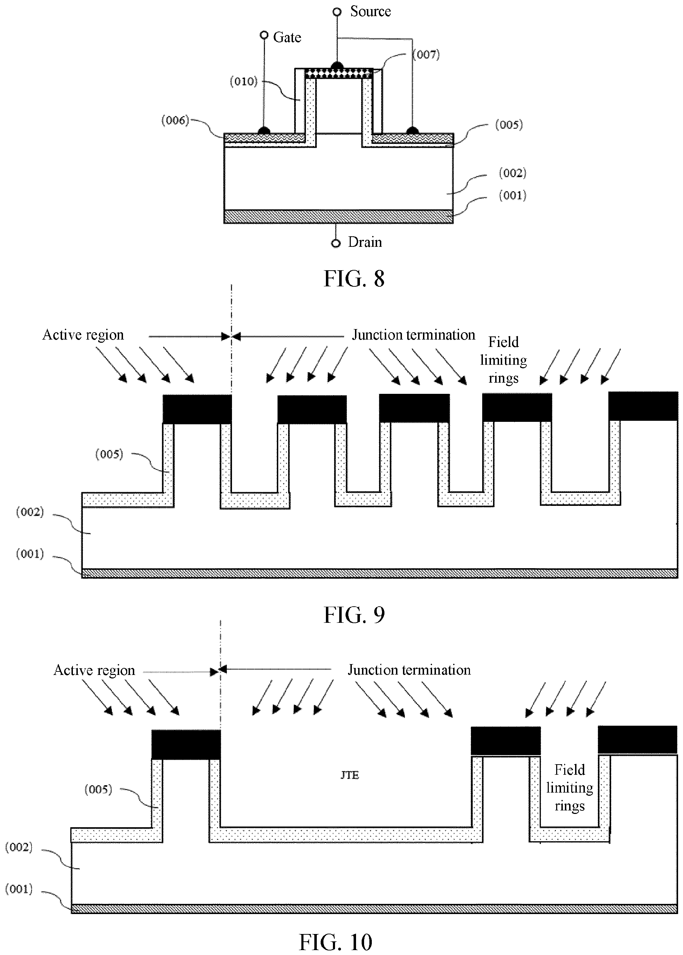

On the basis of Method Embodiment 1 and Method Embodiment 2, with reference to FIG. 8, the method further includes step (f): the gate implantation region 006 on one side of the cell is connected to the gate 008, and the gate implantation region 006 on another side of the cell and the source implantation region 007 are jointly connected to the source 009, so that the structure allows a reduced Cgd, thereby reducing the switching loss.

### Method Embodiment 4

With reference to FIG. 9, an embodiment of the present disclosure further provides a method for preparing a field effect transistor having same gate and source doping, in which the field effect transistor includes a plurality of cell structures and a field limiting ring junction termination. The cell structures are prepared by any of Method Embodiments 1 to 3, and when the junction termination is fabricated, the junction termination and the floating regions of the second conductivity type of the cell structures are etched and implanted simultaneously using the same photolithography mask.

### Method embodiment 5

With reference to FIG. 10, an embodiment of the present disclosure further provides a method for preparing a field effect transistor having same gate and source doping, in which the field effect transistor includes a plurality of cell structures, a junction termination extension, and a junction termination with field limiting rings. The cell structures are prepared by any of Method Embodiments 1 to 3, and when the junction termination is fabricated, the junction termination and the floating regions of the second conductivity type of the cell structures are etched and implanted simultaneously using the same photolithography mask.

Through the above methods, a cell structure for a field effect transistor having same gate and source doping and a field effect transistor having same gate and source doping can be prepared, which will be described in detail below through structure embodiments.

### Structure Embodiment 1

With reference to FIG. 6, a cell structure for a field effect transistor having same gate and source doping prepared by Method Embodiment 1 includes:
a silicon carbide substrate 001 with a doping type of a first conductivity type,
a semiconductor epitaxial layer 002 of the first conductivity type and a first electrode 003 (*i.e.*, a drain as shown in the figure) provided on front and back faces of the silicon carbide substrate 001, respectively; and
a floating region 005 of a second conductivity type, a gate implantation region 006 of the first conductivity type, and a source implantation region 007 of the first conductivity type sequentially provided on the semiconductor epitaxial layer 002 of the first conductivity type, wherein a gate 008 is provided on the gate implantation region 006, a source 009 is provided on the source implantation region, an inter-electrode dielectric 010 is provided between the gate implantation region 006 and the source implantation region 007, and the inter-electrode dielectric 010 is used for isolating the gate 008 from the source 009.

In a preferred application example, the semiconductor epitaxial layer 002 of the first conductivity type has a thickness of 5-250 µm and a doping concentration of 1×10¹⁴ cm⁻³ - 5×10¹⁸ cm⁻³.

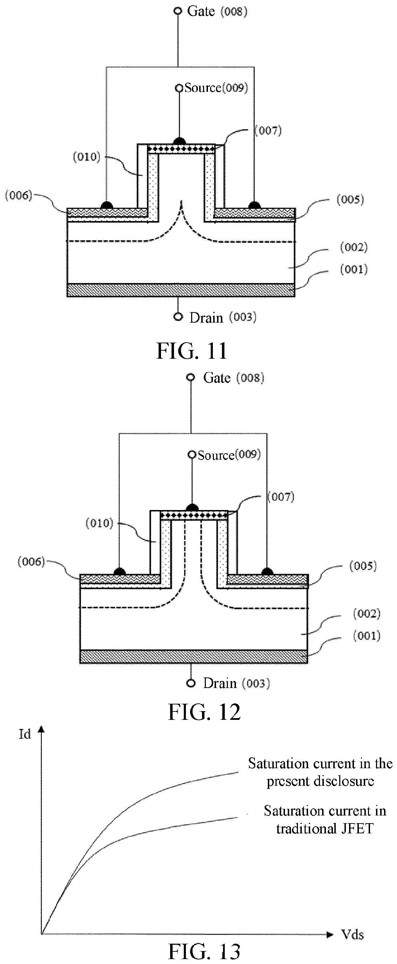

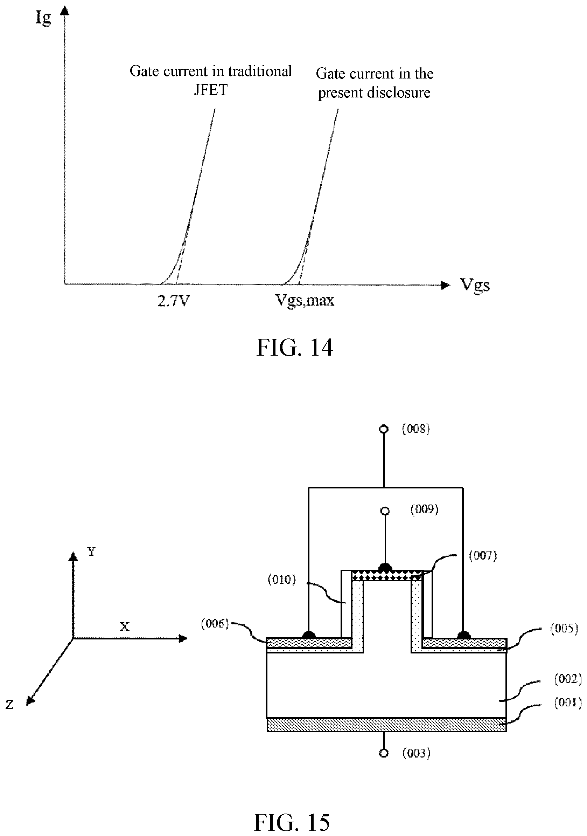

Embodiments of the present disclosure introduce a gate of a first conductivity type and a floating region of a second conductivity type that surrounds the gate on the basis of the traditional JFET to control the channel of the device. A forward bias voltage of the gate of the device can be increased, so that Vgs can be biased at a position greater than a forward cut-in voltage of a PN junction (taking silicon carbide for example, Vgs=20 V). Meanwhile, when Vgs=0 V, because there is no reverse bias introduced by the built-in potential in the PN junction at the channel, the on-resistance of the device is lower. When turned on at a high current, the device enters a saturation state to conduct higher current. That is, compared with the traditional JFET device, the present disclosure improves the voltage that can be applied to the gate and the saturation current, as shown in FIG. 13 and FIG. 14.

In a preferred application example, the doping of the first conductivity type and the second conductivity type is uniform or non-uniform doping of 1×10¹⁴ cm⁻³ - 2×10²¹ cm⁻³.

### Structure Embodiment 2

With reference to FIG. 7, a cell structure for a field effect transistor having same gate and source doping is prepared by Method Embodiment 2. On the basis of Structure Embodiment 1, the channel implantation region 004 is formed by adding at least one tilt implantation on the epitaxial layer.

By adjusting the doping concentrations of the channel implantation region 004 and the floating region 005 of the second conductivity type, a threshold voltage of the JFET device can be adjusted. With reference to FIG. 11, when the device is turned off, a space charge region between the channel implantation region 004 and the floating region 005 of the second conductivity type is closed. With reference to FIG. 12, when the device is turned on, the space charge region is separated.

### Structure Embodiment 3

With reference to FIG. 8, on the basis of Structure Embodiment 1 and Structure Embodiment 2, one gate is connected to the source, so that the structure allows a reduced Cgd, thereby reducing the switching loss.

### Structure Embodiment 4

On the basis of Structure Embodiment 1 and the Structure Embodiment 2, with reference to FIG. 8, the gate implantation region 006 on one side of the cell is connected to the gate 008, and the gate implantation region 006 on another side of the cell and the source implantation region 007 are jointly connected to the source 009, so that the structure allows a reduced Cgd, thereby reducing the switching loss.

### Structure Embodiment 5

With reference to FIG. 9, a field effect transistor having same gate and source doping, provided by an embodiment of the present disclosure, includes a plurality of cell structures according to any of Structure Embodiments 1 to 4 and a field limiting ring junction termination. When the junction termination is fabricated, the junction termination and the floating regions of the second conductivity type of the cell structures are etched and implanted simultaneously using the same photolithography mask.

### Structure Embodiment 6

With reference to FIG. 10, a field effect transistor having same gate and source doping is characterized in that the field effect transistor includes a plurality of cell structures according to any of Structure Embodiments 1 to 4, a junction termination extension, and a junction termination with field limiting rings. When the junction termination is fabricated, the junction termination and the floating regions of the second conductivity type of the cell structures are etched and implanted simultaneously using the same photolithography mask.

### Structure Embodiment 7

With reference to FIG. 15, an embodiment of the present disclosure discloses a cell structure for a field effect transistor having same gate and source doping. FIG. 15 shows a cross-sectional view of an XY plane in a spatial rectangular coordinate system. The cell structure includes:
a silicon carbide substrate 001 with a doping type of a first conductivity type,
a semiconductor epitaxial layer 002 of the first conductivity type and a first electrode 003 provided on front and back faces of the silicon carbide substrate 001, respectively; and
a floating region 005 of a second conductivity type, a implantation region 006 of the first conductivity type gate, and a source implantation region 007 of the first conductivity type sequentially provided on the semiconductor epitaxial layer 002 of the first conductivity type, wherein a gate 008 is provided on the gate implantation region 006 of the first conductivity type, a source 009 is provided on the source implantation region 007 of the first conductivity type, an inter-electrode dielectric 010 is provided between the gate implantation region 006 of the first conductivity type and the source implantation region 007 of the first conductivity type, and the inter-electrode dielectric 010 is used for isolating the gate 008 from the source 009. A portion of the floating region 005 of the second conductivity type in contact with the source implantation region 007 of the first conductivity type has the same structure as the source implantation region 007 of the first conductivity type, and both are provided with terminal sharp angles.

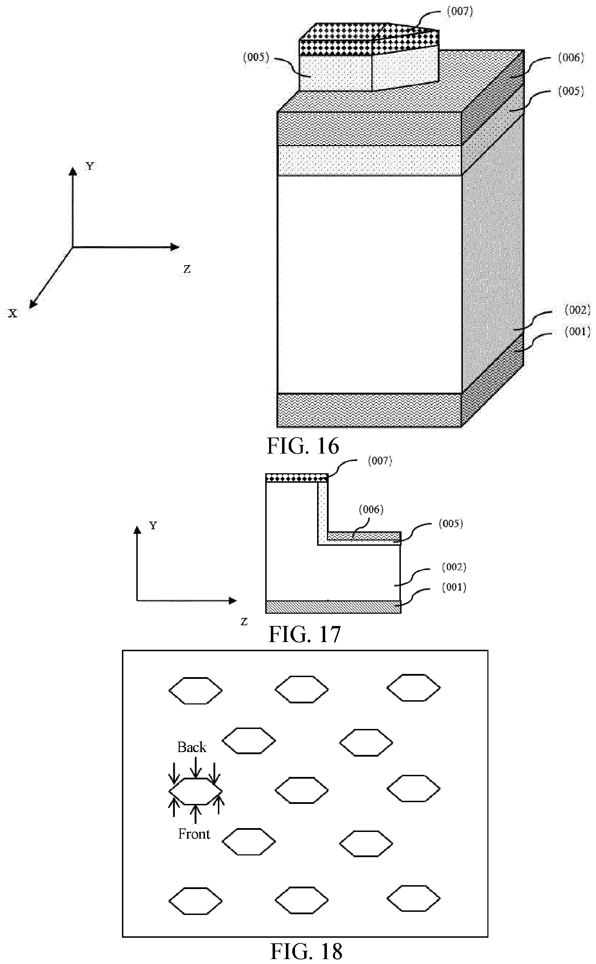

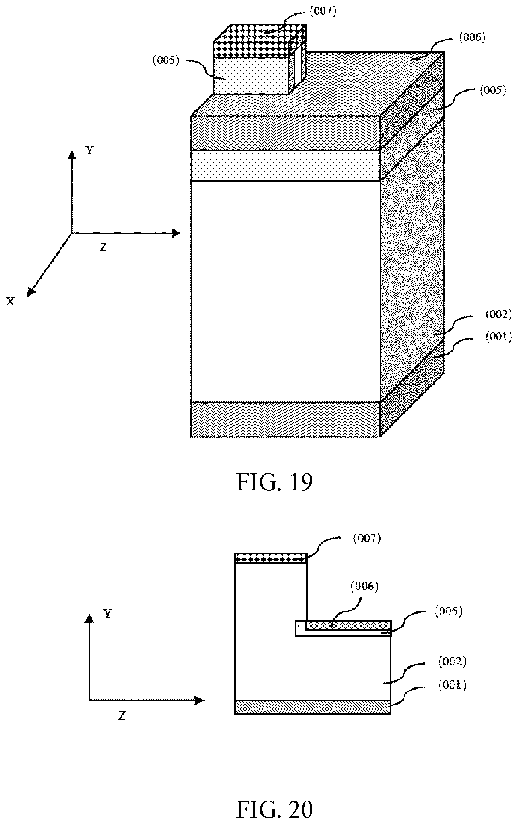

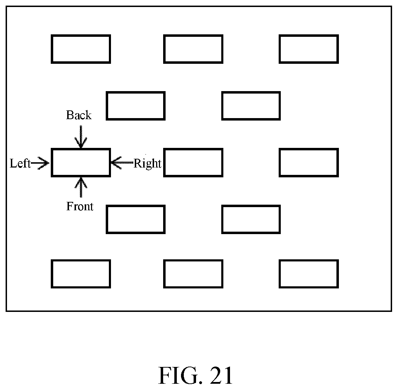

With reference to FIG. 19 to FIG. 21,for the fabrication of devices with the above cross-sectional structures, square and rectangular layouts are often used for etching and implantation. FIG. 19 is a three-dimensional diagram of a smallest half cell structure, FIG. 20 is a cross-sectional view of a YZ plane, and FIG. 21 is a top view of an active region layout of a device with rectangular cells. In the cell structures of JFET devices with the above structures, because a gate of a first conductivity type and a floating region of a second conductivity type that surrounds the gate are introduced to control the channel of the device, implantations in four directions from the front, back, left, and right are required in the trench-based device to avoid a gate-source short circuit. As shown in FIG. 21, only one side of the cell can be implanted each time. If implantations in two directions (only including front and back) are performed, the first conductivity type may run through an edge portion of the cell of the device, resulting in a gate-source short circuit (FIG. 20). In order to shorten the production cycle and reduce the cost, the number of implantations should be reduced as much as possible in practice. Embodiments of the present disclosure avoid this problem by introducing a cell layout structure with terminal sharp angles in the floating region 005 of the second conductivity type. Three front-facing faces of the cell structure may be implanted at the same time during front implantation, and three back-facing faces of the cell structure may also be implanted at the same time during back implantation, as shown in FIG. 18, so that implantations in four directions may be reduced to implantations in two directions, which can shorten the implantation cycle by half. For example, the structures shown in FIG. 19 to FIG. 21 require implantations in four directions, in which the implantation in each direction takes 2 hours, and a total of 8 hours is required, while the structures shown in FIG. 16 to FIG. 18 require implantations in only the front and back directions, in which the implantation in each direction takes 2 hours, and a total of 4 hours is required. As shown in FIG. 16 to FIG. 18, FIG. 16 is a three-dimensional diagram of a smallest half cell structure, FIG. 17 is a cross-sectional view of a YZ plane, and FIG. 18 is a top view of active region layout of a device having cells with terminal sharp angles.

Further, in a specific application example, the terminal sharp angle is 0-180 degrees.

Those skilled in the art can understand that, in some specific application examples, the first conductivity type is N type, and the second conductivity type is P type. In some other application examples, the first conductivity type is P type, and the second conductivity type is N type.

In a preferred application example, the doping of the first conductivity type and the second conductivity type is a uniform or non-uniform doping of 1×10¹⁴ cm⁻³ - 2×10²¹ cm⁻³.

In a preferred application example, the semiconductor epitaxial layer 002 of the first conductivity type has a thickness of 5-250 µm and a doping concentration of 1×10¹⁴ cm⁻³ - 5×10¹⁸ cm⁻³.

It should be understood that the exemplary embodiments described herein are illustrative but not restrictive. Although one or more embodiments of the present disclosure are described in conjunction with the accompanying drawings, those of ordinary skill in the art should appreciate that various changes in form and detail can be made without departing from the spirit and scope of the present disclosure as defined by the appended claims.

## Claims

1. A cell structure for a field effect transistor having same gate and source doping, comprising:
a silicon carbide substrate (001) with a doping type of a first conductivity type,
a semiconductor epitaxial layer (002) of a first conductivity type and a first electrode (003) provided on front and back faces of the silicon carbide substrate (001), respectively; and
a floating region (005) of a second conductivity type, a gate implantation region (006) of the first conductivity type, and a source implantation region (007) of the first conductivity type sequentially provided on the semiconductor epitaxial layer (002) of the first conductivity type, wherein a gate (008) is provided on the gate implantation region (006), a source (009) is provided on the source implantation region, an inter-electrode dielectric (010) is provided between the gate implantation region (006) of the first conductivity type and the source implantation region (007) of the first conductivity type, and the inter-electrode dielectric (010) is used for isolating the gate (008) from the source (009).

2. The cell structure for the field effect transistor having same gate and source doping according to claim 1, wherein a portion of the floating region (005) of the second conductivity type in contact with the source implantation region (007) of the first conductivity type has a same structure as the source implantation region (007) of the first conductivity type, and both are provided with terminal sharp angles.

3. The cell structure for the field effect transistor having same gate and source doping according to claim 2, wherein the terminal sharp angles are 0-180 degrees.

4. The cell structure for the field effect transistor having same gate and source doping according to any one of claims 1 to 3, wherein the semiconductor epitaxial layer (002) of the first conductivity type has a thickness of 5-250 µm and a doping concentration of 1×10¹⁴ cm⁻³ - 5×10¹⁸ cm⁻³.

5. The cell structure for the field effect transistor having same gate and source doping according to any one of claims 1 to 3, wherein the gate implantation region (006) on one side of the cell is connected to the gate (008), and the gate implantation region (006) on another side of the cell and the source implantation region (007) are jointly connected to the source (009).

6. The cell structure for the field effect transistor having same gate and source doping according to any one of claims 1 to 3, wherein a doping of the first conductivity type and the second conductivity type is a uniform or non-uniform doping of 1×10¹⁴ cm⁻³ - 2×10²¹ cm⁻³.

7. The cell structure for the field effect transistor having same gate and source doping according to any one of claims 1 to 3, wherein the first conductivity type is N type, and the second conductivity type is P type.

8. The cell structure for the field effect transistor having same gate and source doping according to any one of claims 1 to 3, wherein the first conductivity type is P type, and the second conductivity type is N type.

9. A field effect transistor having same gate and source doping, comprising a plurality of cell structures according to any one of claims 1 to 8 and a field limiting ring junction termination, wherein when the junction termination is fabricated, the junction termination and the floating regions of the second conductivity type of the cell structures are etched and implanted simultaneously using a same photolithography mask.

10. A field effect transistor having same gate and source doping, comprising a plurality of cell structures according to any one of claims 1 to 8, a junction termination extension, and a junction termination with field limiting rings, wherein when the junction termination is fabricated, the junction termination and the floating regions of the second conductivity type of the cell structures are etched and implanted simultaneously using a same photolithography mask.

11. A method for preparing a cell structure for a field effect transistor having same gate and source doping, comprising following steps:
(a) using a silicon carbide substrate (001) with a doping type of a first conductivity type, and providing a semiconductor epitaxial layer (002) of the first conductivity type on a front face of the silicon carbide substrate (001); using a photolithography plate (photolithography mask) to shield a portion of a surface, and etching a silicon carbide mesa by an etching process, with an etching depth of 0.5 to 5 µm;
(b) performing ion implantation of a floating region by using the same photolithography mask, wherein the specific process comprises forming a floating region (005) of a second conductivity type by at least one tilt implantation and vertical implantation of Al ions, so that bottom and side walls of a trench are uniformly implanted;
(c) peeling off the mask layer and performing vertical N implantation to form a gate implantation region (006) and a source implantation region (007), of the first conductivity type;
(d) growing a dielectric layer on the side walls of the trench as an electrode isolation dielectric (010) to isolate a gate from a source; and
(e) depositing a metal and annealing to form an alloy on surfaces of the gate implantation region (006), the source implantation region (007), and the substrate (001), of the first conductivity type, respectively, as ohmic contacts, wherein the alloy contains at least one of a silicide or a carbide.

12. The method for preparing the cell structure for the field effect transistor having same gate and source doping according to claim 11, wherein step (b) further comprises adding at least one tilt implantation to form a channel implantation region (004) of the first conductivity type.

13. The method for preparing the cell structure for the field effect transistor having same gate and source doping according to claim 11 or 12, wherein the first conductivity type is N type, and the second conductivity type is P type.

14. The method for preparing the cell structure for the field effect transistor having same gate and source doping according to claim 11 or 12, wherein the first conductivity type is P type, and the second conductivity type is N type.

15. A method for preparing a field effect transistor having same gate and source doping, wherein the field effect transistor comprises a plurality of cell structures and a field limiting ring junction termination, the cell structures are prepared by the method according to any of claims 11 to 14, and when the junction termination is fabricated, the junction termination and the floating regions of the second conductivity type of the cell structures are etched and implanted simultaneously using a same photolithography mask.

16. A method for preparing a field effect transistor having same gate and source doping, wherein the field effect transistor comprises a plurality of cell structures, a junction termination extension, and a junction termination with field limiting rings, the cell structures are prepared by the method according to any of claims 11 to 14, and when the junction termination is fabricated, the junction termination and the floating regions of the second conductivity type of the cell structures are etched and implanted simultaneously using a same photolithography mask.
